Europäisches Patentamt

European Patent Office

Office européen des brevets

(19)

(11) Publication number: **0 055 279**
**B1**

# EUROPEAN PATENT SPECIFICATION

(12)

(45) Date of publication of patent specification: **15.02.84**

(51) Int. Cl.³: **H 04 B 1/58**

(21) Application number: **81901891.2**

(22) Date of filing: **29.06.81**

(86) International application number:
**PCT/SE81/00194**

(87) International publication number:
**WO 82/00230 21.01.82 Gazette 82/3**

(54) **ARRANGEMENT FOR ADJUSTING AN ADAPTIVE DIGITAL BALANCE FILTER INCLUDED IN A SUBSCRIBER UNIT.**

(30) Priority: **01.07.80 SE 8004848**

(43) Date of publication of application:
**07.07.82 Bulletin 82/27**

(45) Publication of the grant of the patent:
**15.02.84 Bulletin 84/7**

(84) Designated Contracting States:
**CH DE FR GB LI NL**

(56) References cited:
**US - A - 3 982 080**

(73) Proprietor: **TELEFONAKTIEBOLAGET L M ERICSSON**
**S-126 25 Stockholm (SE)**

(72) Inventor: **SVENSSON, Lars Tommy Edward**
**Eksätravägen 28**
**S-127 33 Skärholmen (SE)**

(74) Representative: **Wennerholm, Kristian**
**TELEFONAKTIEBOLAGET L M ERICSSON**
**S-126 25 Stockholm (SE)**

Courier Press, Leamington Spa, England.

Arrangement for adjusting an adaptive digital balance filter included in a subscriber unit

## TECHNICAL FIELD

The present invention relates to an arrangement for adjusting an adaptive digital balance filter included in one or a plurality of subscriber units, said units being connected to a common selector stage in a telephone exchange. More specifically, the invention relates to an arrangement according to the preamble of claim 1 such that the frequency characteristic included in a subscriber unit can be automatically varied in response to the frequency characteristic of the line impedance connected to the subscriber unit in a given connection, considered from the balance filter out towards the line or the line side.

## BACKGROUND ART

In telecommunications when transmitting and connecting through telephone calls from one subscriber to another, there is a need of separating the transmission directions with the aid of a fork, a so-called hybrid circuit. This divides the incoming two-wire and two-directional line from a subscriber's set to four-wire transmission, ie two one-way connections, to enable signal conversion, filtering, amplification, etc which can only take place in one direction.

When both two-wire subscriber terminals are connected together through a four-wire exchange, it is necessary that the attenuation in the four-wire loop, ie the loop including the hybrid circuit, both one-way four-wire paths and the exchange connection or switching stage exceeds a certain value for the avoidance of stability problems. One possibility is to arrange attenuation in the exchange switching stage, but this results in unnecessary attenuation of the signals which are to be through-connected.

To obtain sufficiently high so-called cross fork attenuation with the object of avoiding the above-mentioned stability problems, and thus obtain sufficient signal separation in the hybrid circuit, the balance impedance in this must accurately match the impedance in the line currently connected to the exchange via the subscriber unit. It is therefore impossible to use the same balance impedance for all subscribers, since, relative to the hybrid circuit, there can be considerable scattering of the input impedances to the different subscriber lines.

The prior art, eg the US Patent 3 982 080, teaches automatically adjusting the value of the balance impedance of a hybrid circuit in response to the impedance value of a given line amongst a plurality of available lines, for thus achieving optimum impedance match between hybrid circuit and line.

## DISCLOSURE OF THE INVENTION

The object of the present invention is to provide an arrangement for adjusting the balance impedance in a subscriber unit of the kind mentioned above, in the case where the balance impedance comprises a digital filter, the frequency characteristic of which can be conventionally varied by varying the parameters supplied to the filter. The proposed arrangement can thus be set up at a central point, eg in close connection to the exchange switching stage, so that it can be individually utilized by several subscribers.

The invention is thereby characterized as will be seen from the characterizing portion of claim 1.

## BRIEF DESCRIPTION OF DRAWINGS

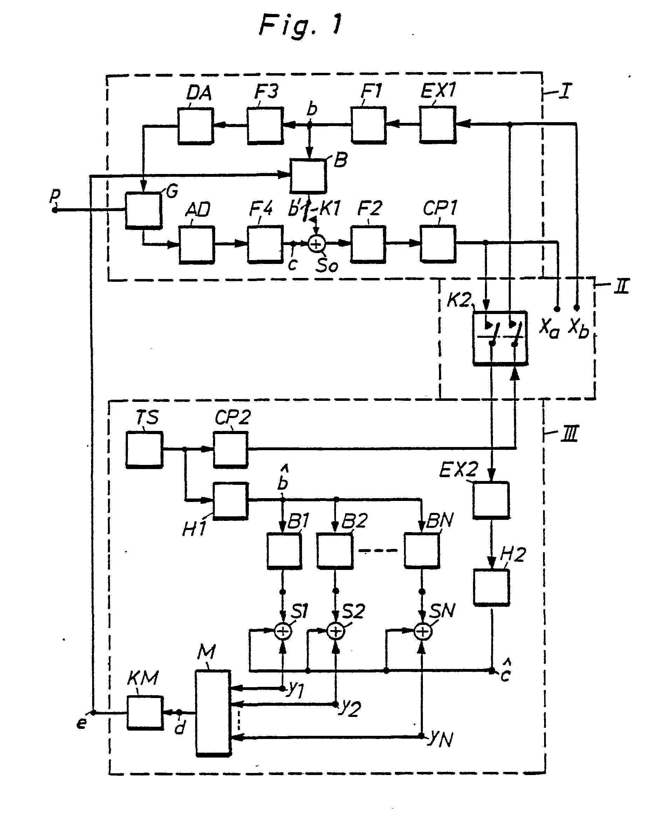

The invention will now be described in detail while referring to the appended drawings, on which Figure 1 is a block diagram of the arrangement according to the invention connected to a subscriber unit;

Figure 2 illustrates a digital filter included as a balance filter in the subscriber unit according to Figure 1;

Figure 3 is a block diagram of a measuring unit and a memory unit included in the selector unit according to Figure 1.

## MODE FOR CARRYING OUT THE INVENTION

The block diagram according to Figure 1 illustrates a subscriber unit I, a switching unit II included in a telephone exchange and a selector unit III. The subscriber unit I is of known embodiment and contains a hybrid circuit G, the input of which consists of a two-wire two-directional connection from a subscriber's set connected to the unit I. The hybrid circuit G is of known embodiment and has the task of dividing the signals across the two-wire connection into two one-way signal paths, but does not contain the balance impedance of the conventional circuits. One signal path includes an analogue/digital converter AD and a digital filter F4, while the second signal path contains a digital/analogue converter DA and a digital filter F3. The hybrid circuit line input is denoted by p. Both signal paths are connected via a balance filter B, which corresponds to the balance impedance in known hybrid circuits, and via a summing circuit So. The loop G, AD, F4, SO, B F3 and DA thus formed constitutes the hybrid circuit proper incorporated in the subscriber unit I. If the attenuation in the units F3, DA and G and to the subscriber across the line is A1, and the attenuation from the subscriber across the line and in the units G, AD and F4 is A2, then the attenuation A3 in the loop is such that A3—A1—A2 >0. Signals from the converter DA in the second signal path must be balanced out by the signals from the balance filter B in the summing circuit SO, said signals passing the hybrid circuit G and reaching the first signal path as being fed out to the line and reflected back again. In a mode already known, the converter AD converts incoming analogue speech signals from the hybrid circuit G to PCM-coded signals, ie into digital signals in the form of binary pulses. The converter DA receives such pulses and converts them to analogue signals, which are sent back to the subscriber after having passed the hybrid circuit G.

In the present embodiment of the subscriber circuit, a plurality of filters F1, F2, F3 and F4 are provided for band limitation of the signals in both signal paths to the prescribed frequency band, eg 0—4 kHz, which corresponds to a speech band, and comprise digital filter links of a known kind. The A—D and D—A conversion suitably takes place at a higher sampling frequency, eg 512 kHz, than that used in the following selector. Apart from band limitation, the task of the filters is then to adjust the sampling frequency in the AD and DA converters to the lower sampling frequency (8 kHz) of the selector. The filter function has thus been divided so that the filters F1 and F3 are connected to one branch for outgoing signals from the subscriber unit, and the filters F2 and F4 for the incoming signals.

The balance filter B is of digital type and has its input connected between the filters F1 and F3, and its output connected to one input of a summing circuit So via a controllable switch K1. The other input of the summing circuit So is connected to the output of the filter F4, and its output is connected to the input of the filter F2. Filters F1 and F2 consist of two substantially similar filters of recursive type, while filters F3 and F4 are transversal filters of substantially the same appearance. A digital compressor unit CP1 and an expander unit EX1 are connected to the respective filters F2, F1 for compressing outgoing signals from filter F2 and expanding incoming signals to the filter F1.

The signals appearing across the terminals Xa and Xb which are those respectively fed out from the compressor unit CP1 and fed to the expander unit EX1 constitute the speech signals which are through-connected in PCM-coded binary form in the following exchange. The block II symbolizes the switching means in the exchange for passing through the signals obtained from the subscriber unit I and received from the selector unit III. The switch K2 is preferably incorporated in the existing selector circuit of the telephone exchange, as a common connecting means, eg for the tone signals to the exchange, the connecting means being in the open position for connected calls. Alternatively, as has been shown in Figure 1 for the sake of clarity, the switch can comprise a unit separate from the other connecting units in the exchange, this unit being activated by the central processor of the exchange only when the selector unit III is to operate, when it passes through the signals from the subscriber unit I to the selector unit III. When the switch K2 is in the closed position, and the selector unit III is thus connected, the switch K1 is controlled so that it is open for disconnecting the balance filter B. In the reverse situation, when the selector unit III is disconnected (the switch K2 open) the balance filter B is connected (connected call).

According to the invention, a selector unit III is thus arranged in the exchange such that for an off-the-hook condition of a subscriber's set, the unit III is connected to the subscriber unit I associated with the subscriber. In accordance with the inventive concept, the selector unit is arranged such that it can serve several subscriber units connected to the common exchange. However, for the sake of clarity, only one switch K2 and one subscriber unit I have been shown in Figure 1, but it will be understood that several subscriber units can be arranged via further switches in the exchange switching unit II for connection to the selector unit III. For this it is only required that the switch K2 is controlled from the exchange processor unit such that when the subscriber unit I according to Figure 1 is not activated, the switch K2 is open, while the corresponding switch associated with an activated unit I (not shown in Figure 1) is closed.

The unit III contains a test signal generator TS, which sends a test signal in digital form, eg a low-frequency signal coded in agreement with the conversion of the speech signals in the subscriber unit I. A digital compressor unit CP2, of the same kind as the compressor unit CP1, is connected between the output of the test signal generator TS and the input of the switch K2. A digital filter H1 is further connected to the output of the test signal generator, the filter being dimensioned such that for the test signal frequency it is similar to filter F1 in the subscriber unit I. More specifically, if the transfer functions for the filters F1 and H1 are

$$F_1(f) = A_1(f) \cdot {}_e j \phi_1(f)$$

and

$$H_1(f) = C_1(f) \cdot {}_e j \theta 1 (f)$$

that

$$A_1(fo) = C_1(fo)$$

and

$$\phi_1(fo) = \theta_1(fo)$$

where fo is the test signal frequency.

The output of the filter H1 is connected to a filter bank. This contains N digital filters B1 ... BN having mutually similar construction but different characteristics corresponding to the characteristic of the transfer function "seen" towards the two-wire line from the terminals b, b' of the balance filter B. The number N is not necessarily the same as the number of subscriber lines, but a filter $B_j$ can correspond to several lines. One input of a plurality of summing circuits S1 ... SN is connected to the output of each filter B1 ... BN. The second input of these summing circuits S1 ... SN is connected to the switch K2 via a digital filter H2 and an expander circuit EX2. The filter H2 is dimensioned such that it imitates the inverse transfer function of the filter F2 for the test signal frequency, ie if the transfer function of the filters F2 and H2 is

$$F_2(f) = A_2(f) \cdot e^{j\phi_2(f)}$$

and

$$H_2(f) = C_2(f) \cdot e^{j\theta_2(f)} \text{ respectively}$$

then $\quad A_2(fo) = 1/C_2(fo)$

and $\quad \phi_2(fo) = -\theta_2(fo),$

where fo = test signal frequency.

Together with the compressor unit CP1 (as well as the units CP2 and EX2) the expander circuit EX1 conventionally forms a companding unit to reduce quantization distorsion of the PCM coding in the subscriber unit I.

The outputs of the summing circuits S1 ... SN are connected to a measuring circuit M. This measures the energy of the output signals $y_1 ... y_N$ from the summing circuits S1 ... SN by forming the mean square value of each of the signals $X_1 ... X_N$ during a suitable time interval eg a test signal period 1/fo, and is connected to the address input of a coefficient memory KM. This memory can be a ROM in which the coefficients for each of the filters B1 ...BN are stored (this will be described in detail later on). The signal $y_k$ of the signals $y_1 ... y_N$ coming to, and measured by the unit M, and which has the least mean square value, ie the least energy, gives an address signal from the measuring circuit M to the coefficient memory KM. The latter is connected to the control input of the balance filter B in the subscriber unit for feeding the selected coefficient array to this filter.

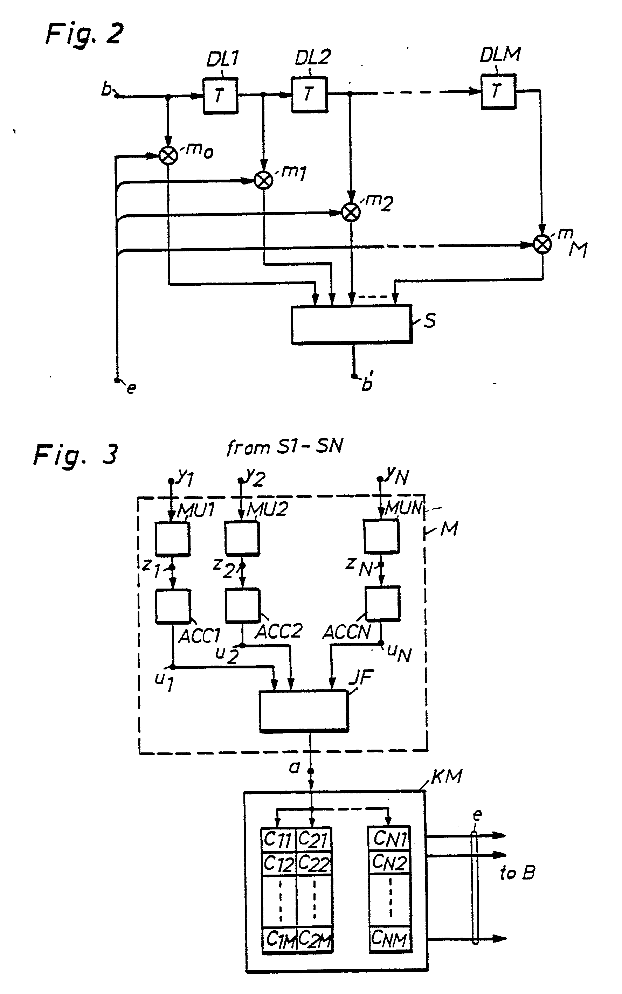

Before describing the function of the selection unit, Figure 2 will be described in more detail, this Figure illustrating an embodiment of the balance filter B. The input b to the filter B is connected to a plurality of delay links DL1 ... DLM. The inputs of each delay link, as well as the output of the last link DLM are connected to a plurality of controllable digital multipliers $m_0 ... m_M$, and the outputs thereof are connected to a summer S. Each delay link DL1 ... DLM has a delay determined by the sampling rate of the incoming signals to the filter B, eg 16 kHz, if the sampling rate of the signals coming from the exchange is multiplied by a factor of 2 in the filter F1. The control inputs of the multipliers are connected to the N outputs of the coefficient memory KM in the selector unit III. The filter B thus constitutes an adaptive transversal filter, obtaining control signals from a memory unit KM to give an array of coefficients, whereby the required filter characteristic of the filter B is obtained. Determining of the coefficient array required for the filter B to give the best balancing for a given subscriber line is executed by the selector unit III.

When the subscriber's telephone set is in the off-hook condition, a signal is sent to the exchange such that the selector unit III is connected to the subscriber station I via the switch K2. The switch K1 is controlled such that it is simultaneously open. The test signal generator TS transmits a sampled sinusoidal test signal, generator TS is a sampled sinusoidal test signal, eg the connecting tone in a sampled form, which is compressed in the unit CP2 and expanded in the unit EX1 according to a prescribed compander law. The attenuation and phase shift of the test signal are the same in the filters F1 and H1. The signals appearing at the points b and b' are thus substantially the same. The signal a the point b continues across the filter F3, converter DA, hybrid circuit G and subscriber line and is reflected back to the subscriber telephone set across the line, hybrid circuit G, converter AD and filter F4 to the point c. The signal path from the point b through said units and line to the point c are thus equivalent with a filter F, the transfer function $F(f) = F_1(f) \cdot e^{j\Psi(f)}$ of which shall be similar to the transfer function B(f) of the balanced filter, but with reverse sign. If the signal applied to the input of the balance filter B and the filter F3 is denoted by x(t) with the frequency function X(f) and the output signal from the summator So is denoted by y(t) with the frequency function Y(f) then

$$Y(f) = X(f)[\overline{F(f)} + B(f)],$$

where F(f) and B(f) are the transfer functions for the equivalent filter F and the balance filter B, respectively.

When the switch K1 is open, ie the switch K2 is closed, then from the signalling point of view the points b, c are equal to the points $\hat{b}$, $\hat{c}$. The signal point in $\hat{b}$ is thus approximately the same as x(t) and the signal at point $\hat{c}$ is approximately the same as y(t). Each of the filters B1 ... BN, constituting the filter bank in the selector unit III, has been dimensioned so that they as closely as possible are similar to the equivalent filter F, according to the above, for a certain number of lines. Thus, each filter $B_k$ (k = 1, ..., N) and each summator $S_k$ (k = 1, ..., N) in the selector unit III corresponds to the balance filter B and summator So, respectively. So that equilizing of the signals shall take place in the summator So (when the switch K1 is closed and K2 opened) the signal

$$Y(f) = X(f) \ [F(f) + B(f)]$$

shall be as small as possible, ie the factor $[F(f) + B(f)]$ shall be as small as possible, which implies that the balance filter matches the line impedance. The signal $y_k(t)$ can therefore be taken as a measure of how closely the transfer function of one of the filters B1 ... BN is similar to the transfer function of the equivalent filter F with reverse sign.

The least value of $[F(f) + B(f)]$ is consequently determined in the selector unit III by determining the value of k ($k = 1, ..., N$) of the signal $y_k(t)$ which has the least energy. The energy of the signal $y_k(t)$ from the summator $S_k$ can be denoted by:

$$\int | y_k(t) |^2 dt = \int |Y_k(f) |^2 df = \int | X(f) |^2 | F(f) + B_k(f) |^2 df$$

ie the factor $| F(f) + B_k(f) |^2$ is least when $\int | y_k(t) |^2 dt$ is least. The measuring unit M therefore forms a mean square value of all output signals from the summator circuits S1 ... SN, and a signal across its output ê is transmitted to the coefficient memory KM which gives the order number k of the filter $B_k$, for which is obtained the lowest energy of the signal $y_k(t)$ across the output of the associated summator $S_k$. The output signal from the unit M is a binary address information to the coefficient memory KM, which selects in this memory the coefficient array $C_{kM}$ associated with the filter $B_k$. Associated coefficients are after that fed from the memory KM, eg in parallel form, to the multiplier circuits $m_o = m_M$ in the balance filter B.

The filters B1 ... BN are suitably implemented as digital transversal filters of the same kind as the balance filter according to Figure 2, with the difference that the digital multipliers in the filters B1 ... BN are not variable but have fixed multiplying values, calculated by measuring of the line impedance values for the subscriber lines which are connected to the exchange.

The measuring unit M and the subsequent coefficient memory KM are illustrated in more detail in Figure 3. The measuring unit contains N multipliers MU1 ... MUN, the inputs of which form the N inputs of the unit M. Each multiplier forms the square of an incoming signal $y_i$ to give a value $z_i = y_i^2$ at the output. An accumulator circuit AC1 ... ACCN is connected to each multiplier output for summing the squared sample values for each $Z_i$ signal, eg during a time corrresponding to the period of the sinusoidal test signal from the generator TS. A comparator circuit JF compares the thus formed values

$$u_i = \sum_{k=o}^{T} z(t_k) = \sum_{k=o}^{T} y_i^2(t_k);$$

($i = 1, ..., N$) and gives an address signal in binary form at its output, giving the order number $i$ of the signal with the least value.

The coefficient memory KM comprises, for example, of an addressable ROM memory in which the coefficients $C_{ik}$ ($i = 1, ..., N \ k = 1, ... M$) are stored for the N filters B1 ... BN. Addressing from the measuring unit M results in that the selected coefficients are transferred in parallel form to the multipliers $m_o ... m_M$ in the balance filter B in the mode described above.

The arrangement in accordance with the invention can naturally be modified within the scope of the inventive concept. For example, the test signal generator can send a signal containing two frequencies, one in the lower and the other in the upper range of the speech band. This is suitable in the cases where pupinized lines are used. The transfer functions for the filters F1, H1 and F2, H2 must then satisfy the relationships given above for both these frequencies.

A suitable sampling rate in the filter B is determined by the filters F1, F3 in the first signal path and the filters F2—F4 in the second. As an example, is has been assumed above that the sampling rate in the converters DA and AD is 512 kHz and that the filters F3, F4 adjust the sampling frequency to 16kHz in the filter B. Alternatively, the filter B can operate at a greater rate, and in the extreme case be directly connected to the input of the converter DA or the output of the converter AD (via the summator So), or at a lower rate by connection to the input of the filter F1 or the output F2, the sampling rate then being 8 kHz.

The parallel connection of the filters B1 ... BN in the filter bank is advantageous, since possible disturbance signals from the subscriber then have the same effect on all the filter signals on summing in the summators S1 ... SN.

Finally, it is not necessary to select as a criterion of the berst adjustment of the filter B to the line impedance the output signals from the summators S1 ... SN which has least energy. It is also possible to form the absolute value of the signal y(t) and use the least value of this as a criterion.

## Claims

1. Arrangement for adjusting an adaptive digital balance filter (b) included in each of a plurality of subscriber units (I), commonly connected to a telephone exchange, in response to the impedance of a line connected to a subscriber unit, where each such unit contains, apart from the balance filter (B), a two-wire to four-wire transfer circuit (G) between an incoming two-wire line and both four-wire branches, a switch (K1) for connecting and disconnecting the balance filter between said branches, filter units (F1, F2, F3, F4) and converter units (AD, DA) in each of the branches, characterized by a switching unit (II) connected to both four-wire branches for connecting a selector unit (III) to one of said subscriber units (I) simultaneously as the balance filter (B) is disconnected from said branches, wherein the selector unit includes:

a) a test signal generator (TS) for transmitting a periodic test signal in digital form containing at least one tone frequency (fo) across a loop containing one of the four-wire branches, the subscriber line and the other four-wire branch,

b) a filter bank containing N digital filters (B1 ... BN) connected in parallel for receiving a signal corresponding to the test signal across the input of the balance filter, the transfer function of each filter in the bank corresponding to the transfer function of the equivalent filter formed by the line impedance of each of at least N lines, which are connected to the subscriber unit (I) and to the part of said loop which is connected to the balance filter (B),

c) a plurality of N summing circuits (S1 ... SN) for summing the test signal which has gone through said loop with the same test signal filtered in said filter in the filter bank,

d) a measuring unit (M) for forming a criterion from the signals (y1 ... yN) obtained from said summing circuits (S1 ... SN) with relation to the one (Bk) of said filters (B1 ... BN) the transfer function of which best matches the transfer function of said equivalent filter,

e) a memory unit (KM) storing a plurality of filter parameters ($C_{ik}$) corresponding to the parameters of each of the filters (B1 ... BN) in the filter bank and which, in dependence on the signal (d) obtained from the measuring circuit (M), transmits signals (e) to the balance filter (B) corresponding to the parameters of the filter in the bank, the output signal of which in the measuring circuit meets said criterion after summing in said summing circuits (S ... SN).

2. Arrangement as claimed in claim 1, characterized in that the measuring unit (M) forms said criterion by measuring the energy of the signals (y1 ... yN) obtained from the summing circuits (S1 ... SN), the order number (k) for the filter in the filter bank giving the signal (yk) having least energy is determined for selecting associated parameters ($C_{ik}$) in the memory unit (KM).

3. Arrangement as claimed in claim 2, characterized in that the measuring unit (M) contains a plurality of N multipliers (MU1 ... MUN) for forming the square of the signals (y1 ... yN) given by the summing circuits (S1 ... SN), a plurality N of accumulator circuits (ACC1 ... ACCN) for summing the signals (z1 ... zN) obtained from the multiplier circuits during a time corresponding to a plurality of periods of the periodic test signal, and a comparator circuit (JF) for comparing the output signals (u1 ... uN) from the accumulator circuits and for giving an address signal to the memory (KM), which selects the parameter array ($C_{ik}$) in the memory unit which fulfills said criterion.

4. Arrangement as claimed in any of claims 1—3, characterized in that each filter (B1 ... BN) in the filter bank comprises a digital transversal filter containing M delay links (DL1 ... DLM), the input of the filter as well as the output of each of the delay links being connected to controllable digital multipliers (mo ... mM), which receive said signals from the memory unit (KM) across their control inputs, their outputs being connected to a summator (S) the output of which forms the filter output.

## Revendications

1. Dispositif pour régler un filtre d'équilibrage numérique adaptatif (B) incorporé dans chacune de plusieurs unités d'abonnés (I), communément connectées à un central téléphonique, en réponse à l'impédance d'une ligne connectée à une unité d'abonné, dans lequel chacune de ces unités contient, hormis le filtre d'équilibrage (B), un circuit (G) de transfert de deux fils à quatre fils entre une ligne d'entrée à deux fils et deux branches à quatre fils, un commutateur (K1) destiné à connecter et déconnecteur le filtre d'équilibrage entre lesdites branches, des unités de filtrage (F1, F2, F3, F4) et des unités de conversion (AD, DA) dans chacune des branches, caractérisé par une unité de commutation (II) connectée aux deux branches à quatre fils pour connecter une unité de sélection (III) à l'une desdites unités (I) d'abonnés en même temps que le filtre d'équilibrage (B) est déconnecté desdites branches, dans lequel l'unité de sélection comprend:

a) un générateur (TS) de signal d'essai destiné à émettre un signal d'essai périodique sous une forme numérique contenant au moins une fréquence de tonalité (fo) à travers une boucle contenant l'une des branches à quatre fils, la ligne d'abonné et l'autre branche à quatre fils,

b) une rangée de filtres contenant N filtres numériques (B1 ... BN) connectés en parallèle pour recevoir un signal correspondant au signal d'essai appliqué à l'entrée du filtre d'équilibrage, la fonction de transfert de chaque filtre de la rangée correspondant à la fonction de transfert du filtre équivalent formé par l'impédance de la ligne de chacune d'au moins N lignes, qui sont connectées à l'unité d'abonné (I) et à la partie de ladite boucle qui est connectée au filtre d'équilibrage (B),

c) un groupe de N circuits de sommation (S1 ... SN) destinés à la sommation du signal d'essai qui a franchi ladite boucle avec le même signal d'essai filtré dans ledit filtre de la rangée de filtres,

d) une unité de mesure (M) destinée à former un critère à partir des signaux (y1 ... yN) provenant desdits circuits de sommation (S1 ... SN) par rapport à l'un (Bk) desdits filtres (B1 ... BN) dont la fonction de transfert s'adapte le mieux à la fonction de transfert dudit filtre équivalent,

e) une unité de mémoire (KM) mémorisant plusieurs paramètres de filtre $(C_{ik})$ correspondant aux paramètres de chacun des filtres (B1 ... BN) de la rangée de filtres et qui, suivant le signal (d) obtenu auprès du circuit de mesure (M), transmet des signaux (e) au filtre d'équilibrage (B) correspondant aux paramètres du filtre de la rangée dont le signal de sortie dans le circuit de mesure satisfait lesdits critères après sommation dans lesdits circuits de sommation (S1 ... SN).

2. Dispositif selon la revendication 1, caractérisé en ce que l'unité de mesure (M) forme ledit critère par mesure de l'énergie des signaux (y1 ... yN) provenant des circuits de sommation (S1 ... SN), le numéro d'ordre (k) du filtre de la rangée de filtres donnant le signal (yk) ayant la plus faible énergie est déterminé pour choisir des paramètres associés $(C_{ik})$ dans l'unité de mémoire (KM).

3. Dispositif selon la revendication 2, caractérisé en ce que l'unité de mesure (M) contient un groupe de N multiplicateurs (MU1 ... MUN) destinés à former le carré des signaux (y1 ... yN) donnés par les circuits de sommation (S1 ... SN), un groupe de N circuits accumulateurs (ACC1 ... ACCN) destiné à réaliser la sommation des signaux (z1 ... zN) provenant des circuits multiplicateurs pendant une durée correspondant à plusieurs périodes du signal périodique d'essai, et un circuit comparateur (JF) destiné à comparer les signaux de sortie (u1 ... uN) des circuits accumulateurs et à donner un signal d'adresse à la mémoire (KM), qui sélectionne l'ensemble de paramètres $(C_{ik})$ dans l'unité de mémoire remplissant ledit critère.

4. Dispositif selon l'une quelconque des revendications 1—3, caractérisé en ce que chaque filtre (B1 ... BN) de la rangée de filtres comprend un filtre transversal numérique contenant M lignes de retard (DL1 ... DLM), l'entrée du filtre ainsi que la sortie de chacune des lignes de retard étant connectées à des multiplicateurs numériques contrôlables (mo ... mM) qui reçoivent lesdits signaux de l'unité de mémoire (KM) à leurs entrées de commande, leurs sorties étant connectées à un élément de sommation (S) dont la sortie forme la sortie du filtre.

## Patentansprüche

1. Vorrichtung zur Anpassung eines adaptiven digitalen Balance- oder Kompensationsfilters (B), welches in jeder von mehreren Teilnehmereinheiten (I) angeordnet und normalerweise mit einer Fernsprechzentrale verbunden ist, in Abhängigkeit von der Impedanz einer mit der Fernsprecheinrichtung verbundenen Leitung, wobei jede Einheit außer dem Balance- oder Kompensationsfilter (B) eine Zweidraht- bis Vierdraht-Übertragungsschaltung (G) zwischen einer ankommenden Zweidraht-Leitung und zwei Vierdraht-Verzweigungen, einen Schalter (K1) zum Verbinden und Abtrennen des Balance- oder Kompensationsfilters zwischen diesen Zweigen, Filtereinheiten (F1, F2, F3, F4) und Konvertereinheiten (AD, DA) in jedem der Zweige aufweist, dadurch gekennzeichnet, daß eine Schalteinheit (II) vorgesehen ist, die mit beiden Vierdraht-Abzweigungen verbunden ist, um eine Selektor- oder Wählereinheit (III) mit einer der Teilnehmereinheiten (I) gleichzeitig mit dem Abtrennen des Balance- oder Kompensationsfilters (B) von diesen Abzweigungen zu verbinden, wobei die Selektroeinheit folgende Merkmale umfaßt:

a) einen Testsignalgenerator (TS) zur Übertragung eines periodischen Testsignals in digitaler Form mit mindestens einer Tonfrequenz (fo) über eine Leitung oder Schleife, die eine der Vierdraht-Abzweigungen, die Teilnehmerleitung und die andere Vierdraht-Abzweigung aufweist,

b) eine Filterreihe, die N-digitale Filter (B1 ... BN) enthält, die parallel zueinander geschaltet sind und die ein dem Testsignal über dem Eingang des Balanceoder Kompensationsfilters entsprechendes Signal empfangen, wobei die Übertragungsfunktion jedes Filters in der Filterreihe der Übertragungsfunktion des äquivalenten Filters entspricht, das durch die Leitungsimpedanz jeder Leitung von mindestens N-Leitungen gebildet wird, die mit der Fernsprecheinheit (I) und mit dem Teil der Schleife verbunden sind, der mit dem Balance- oder Kompensationsfilter (B) in Verbindung steht.

c) eine Vielzahl von N Summierschaltung (S1 ... SN) zur Summierung des durch die Schleife gelangten Testsignals mit demselben Testsignal, welches in dem Filter der Filterreihe gefiltert wurde.

d) eine Meßeinheit (M) zur Bildung eines Kriteriums aus den Signalen (y1 ... yN), die aus den Summierschaltungen (S1 ... SN) erhalten werden, mit Bezug auf das eine (Bk) der Filter (B1 ... BN), dessen Übertragungsfunktion am besten an die Übertragungsfunktion des äquivalenten Filters angepaßt ist,

e) eine Speichereinheit (KM) zur Speicherung einer Vielzahl von Filterparametern $(C_{ik})$, die den Parametern jedes der Filter (B1 ... BN) in der Filterreihe entsprechen und die in Abhängigkeit von dem von der Meßschaltung (M) erhaltenen Signal (d), Signale (e) auf das Balance- bzw. Kompenationsfilter (B) überträgt, die den Parametern der Filterreihe entsprechen, wobei deren Ausgangssignal in der Meßschaltung das Kriterium nach der Summierung in den Summierungsschaltungen (S1 ... SN) erfüllt.

2. Vorrichtung nach Patentanspruch 1, dadurch gekennzeichnet, daß die Meßeinheit (M) das Kriterium durch Messen der Energie der von den Summierungsschaltungen (S1 ... SN) enthaltenen Signale (y1 ... yN) bildet bzw. schafft, wobei die Ordnungszahl (k) für die Filter in der Filterreihe, die die Signale (yk) mit der geringsten Energie abgeben, zur Auswahl der verbundenen Parameter ($C_{ik}$) in der Speichereinheit (KM) bestimmt wird.

3. Vorrichtung nach Patentanspruch 2, dadurch gekennzeichnet, daß die Meßeinheit (M) eine Vielzahl von N Multiplizierern (MU1 ... MUN) zur Bildung des Quadrats der von den Summierschaltungen (S1 ... SN) abgegebenen Signale (y1 ... yN), eine Vielzahl N von Akkumulatorschaltungen (ACC1 ... ACCN) zur Summierung der von den Multiplizierschaltungen während eine Zeit, die einer Vielzahl von Perioden des periodischen Testsignals entspricht, erhaltenen Signale ($Z_1$ ... ZN) und eine Komparatorschaltung (JF) zum Vergleichen der Ausgangssignale (u1 ... uN) der Akkumulatorschaltungen und zur Abgabe eines Adressensignals an die Speichereinheit (KM) aufweist, welche die Parameterreihe ($C_{ik}$) in der Speichereinheit auswählt, die das Kriterium erfüllt.

4. Vorrichtung nach einem der Patentanspruch 1 bis 3, dadurch gekennzeichnet, daß jedes Filter (B1 ... BN) der Filterreihe ein digitales Transversalfilter aufweist, welches M Verzögerungsweige (DL1 ... DLM) enthält, daß der Eingang des Filters sowie der Ausgang jedes der Verzögerungszweige mit steuerbaren Digital-Multiplizierern (mo ... mM) verbunden sind, die die Signale der Speichereinheit (KM) über ihre Steuereingänge erhalten, und daß ihre Ausgänge mit einem Summierer (S) verbunden sind, dessen Ausgang den Filterausgang bildet.

# Fig. 1

Fig. 2

Fig. 3

from S1 – SN